# EUROPÄISCHE PATENTANMELDUNG

(11) **EP 3 537 038 A1**
(43) Veröffentlichungstag der Anmeldung: **11.09.2019**
(21) Anmeldenummer: 19161046.8
(22) Anmeldetag: 06.03.2019
(51) Int. Cl.: F21V 15/01, F21S 4/24, F21Y 103/10, F21Y 103/20, F21Y 107/70, F21Y 115/10, H01L 25/075, H01L 33/52, H01L 33/58, H05B 33/04

(54) **VERKAPSELUNGSSCHLAUCH FÜR EIN LINEARES LEUCHTDIODENMODUL UND LINEARES LEUCHTDIODENMODUL DAMIT**

(30) Priorität: 09.03.2018 DE 102018105494
(71) Anmelder: Bilton International GmbH, 5760 Saalfelden (AT)
(72) Erfinder: KNOFLACH, Norbert, 5722 Niedernsill (AT); MICHAL, Roland, 1230 Wien (AT); OBERLECHNER, Christian, 5760 Saalfelden (AT)
(74) Vertreter: Epping - Hermann - Fischer

(57) **Zusammenfassung**

Es ist ein Verkapselungsschlauch (10) für ein mindestens ein LED-Lichtband (20) aufweisendes lineares Leuchtdiodenmodul, mit einem entlang dessen Längsrichtung allseitig geschlossenen vorgefertigten Profil angegeben. Das Profil ist mit einem in Längsrichtung vollständig durch den Verkapselungsschlauch (10) verlaufenden LED-Kanal (13) versehen, der dazu vorgesehen ist, in diesen das LED-Lichtband (20) einzuziehen. Der LED-Kanal (13) ist einerseits von einem lichtreflektierenden Trägerelement (11) und andererseits von einem lichtdurchlässigen Fensterelement (12) begrenzt. Das Fensterelement (12) weist mindestens einen entlang des LED-Kanals (13) verlaufenden Opto-Kanal (16) auf, der dazu ausgebildet ist, für die vom LED-Lichtband (20) ausgesandte Strahlung eine vorbestimmte optische Wirkung hervorzurufen, und/oder der dazu vorgesehen ist, in diesen mindestens ein Opto-Element (40) einzuziehen. Des Weiteren ist ein lineares Leuchtdiodenmodul angegeben.

## Beschreibung

Die vorliegende Erfindung betrifft einen insbesondere flexiblen Verkapselungsschlauch für ein insbesondere flexibles lineares Leuchtdiodenmodul, bei dem eine Mehrzahl von
- LED-Bauelementen - beispielsweise mit einer leadframebasierten Kunststoffumhüllung versehene LED-Chips wie beispielsweise PLCC2 SMD LEDs, PLCC4 SMD LEDs oder PLCC6 SMD LEDs) - beispielsweise in Oberflächen(SMD)-Montagetechnologie oder
- eine Mehrzahl von LED-Chips in Chip-on-board (COB)-Technologie
auf einer langgestreckten flexiblen Leiterplatte (auch Flex-PCB genannt) montiert und elektrisch verschaltet ist. Die LED-Bauelemente bzw. LED-Chips sind dabei vorzugsweise linear hintereinander auf dem Flex-PCB montiert.

Die lichtemittierenden Halbleiterkörper der LED-Chips können dabei auf anorganischen oder organischen elektrolumineszierenden Materialien basieren.

LED-Bauelement und LED-Chip werden im Folgenden einheitlich mit "LED" bezeichnet. Das Flex-PCB mit den LEDs wird im Folgenden mit "LED-Lichtband" bezeichnet.

Ein solches LED-Lichtband muss, um es vor mechanischer Beschädigung sowie vor Staub, Wasser und anderen Umwelteinflüssen zu schützen, mit einer Verkapselung versehen sein.

Vorliegend ist als Verkapselung ein entlang der Längsrichtung des linearen Leuchtdiodenmoduls allseitig geschlossenes vorgefertigtes Profil mit einem in Längsrichtung durchgängigen Hohlraum (mit anderen Worten ein vorgefertigter Verkapselungsschlauch - im Folgenden "Verkapselungsschlauch" bezeichnet) vorgeschlagen, in den das LED-Lichtband eingeschoben und montiert ist. Der Verkapselungsschlauch umfasst ein über seine gesamte Länge verlaufendes lichtreflektierendes und/oder lichtlenkendes Trägerelement und ein über seine gesamte Länge verlaufendes lichtdurchlässiges Fensterelement.

Die begrenzenden Seitenflächen des Hohlraums sind zu einem ersten Teil über die gesamte Länge des Verkapselungsschlauches von dem lichtreflektierenden und/oder lichtlenkenden Trägerelement und zu einem zweiten Teil über die gesamte Länge des Verkapselungsschlauches von dem lichtdurchlässigen Fensterelement begrenzt. Das Trägerelement und das Fensterelement bilden zusammen den Verkapselungsschlauch aus. Im Folgenden ist der von dem Trägerelement und dem Fensterelement gebildete Hohlraum als "LED-Kanal" bezeichnet.

Eine solche Verkapselung ist beispielsweise in der US 2017/0023192 A1 beschrieben, deren Offenbarungsgehalt insofern hiermit durch Rückbezug aufgenommen wird.

Das LED-Lichtband ist derart auf dem Trägerelement angeordnet, dass zumindest ein Großteil des von den LEDs emittieren Lichts in das Fensterelement gelangt.

Der Verkapselungsschlauch kann mittels Co-Extrusion hergestellt sein. Geeignete Materialien für das Trägerelement sind beispielsweise Silikon-, PVC- oder PUR-Materialien sowie Kombinationen dieser Materialien, welche beispielsweise mit einem Füllstoff gefüllt sind, der eine von den LED-Chips emittierte Strahlung reflektiert. Geeignete Materialien für das Fensterelement sind beispielsweise transparente oder transluzente Silikon-, PVC- oder PUR-Materialien sowie Kombinationen dieser Materialien.

Der vorliegenden Erfindung liegt insbesondere die Aufgabe zugrunde, den Verkapselungsschlauch insbesondere hinsichtlich einer variablen Ausgestaltung von entsprechenden linearen Leuchtdiodenmodulen weiterzubilden.

Diese Aufgabe wird mit den Merkmalen des Patenanspruches 1 gelöst. Ein lineares Leuchtdiodenmodul mit einem solchen Verkapselungsschlauch ist in Anspruch 8 angegeben. Vorteilhafte Ausgestaltungen des Verkapselungsschlauches bzw. des linearen Leuchtdiodenmoduls sind in den Unteransprüchen angegeben. Der Offenbarungsgehalt der Patentansprüche wird hiermit durch Rückbezug in die vorliegende Beschreibung aufgenommen.

Bei dem Verkapselungsschlauch weist das Fensterelement mindestens einen entlang des LED-Kanals verlaufenden Kanal auf, der für die von den LEDs ausgesandte Strahlung eine vorbestimmte optische Wirkung hervorruft und/oder der dazu vorgesehen ist, mindestens ein dahingehend optisch wirksames Element (im Folgenden "Opto-Element"), beispielsweise ein Band oder einen Streifen mit linear über die gesamte Länge des LED-Lichtbandes angeordneten optischen Elementen, in den Verkapselungsschlauch einzuziehen. Damit können Beleuchtungseigenschaften eines entsprechenden linearen Leuchtdiodenmoduls anwendungsspezifisch eingestellt werden. Dieser Kanal wird im Folgenden als "Opto-Kanal" bezeichnet.

Beispielsweise weist der Opto-Kanal selbst oder das Opto-Element lichtstreuende Eigenschaften auf, beispielsweise vermittels Streupartikel. Zusätzlich oder alternativ gibt der Opto-Kanal selbst oder das in diesen eingezogene Opto-Element den Abstrahlwinkel des linearen Leuchtdiodenmoduls vor und/oder ruft eine asymmetrische Abstrahlung des LED-Lichtbandes hervor.

Ebenso kann beispielsweise mittels geeigneter Formgebung des Fensterelements und Verwendung einer asymmetrischen Linearlinse in einem seitlich zum LED-Lichtband verlaufenden Opto-Kanal mittels eines Topview-LED-Lichtbandes ein lineares Sideview-Leuchtdiodenmodul realisiert werden.

Mit einem Verkapselungsschlauch gemäß der Erfindung oder einer ihrer Ausgestaltungen können auf technisch einfache Weise komplex aufgebaute lineare Leuchtdiodenmodule bereitgestellt werden, welche zudem den Anforderungen der Schutzklasse IP67 genügen.

Ein flexibles lineares LED-Lichtband zur Verwendung in einem linearen Leuchtdiodenmodul gemäß einer der vorliegend erläuterten Ausführungsformen, Ausgestaltungen und Ausführungsbeispielen ist beispielsweise im Datenblatt BLONE1300024DC12000830000W20 (verfügbar unter https://cdn2.regroshop.at/medias/sys Regro/sheets/sheets/h03/ hd8/9006597767198/Te-BL124120003020.pdf) beschrieben. Hierbei handelt es sich um ein Topview-LED-Lichtband, bei dem die optischen Abstrahlachsen der auf dem Flex-PCB montierten LED-Bauelemente nominal senkrecht zur Montagefläche des Flex-PCBs verlaufen. Alternativ zu einem flexiblen linearen LED-Lichtband kann, falls kein flexibles lineares Leuchtdiodenmodul vorgesehen ist, auch ein starres lineares LED-Lichtband verwendet sein.

Der Verkapselungsschlauch und das lineare Leuchtdiodenmodul werden im Folgenden anhand von Ausführungsbeispielen in Verbindung mit den Figuren 1 bis 4 näher erläutert. Es zeigen:
Figur 1, eine schematische Darstellung eines Schnittes durch ein erstes Ausführungsbeispiel des Verkapselungsschlauches;
Figur 2, eine schematische Darstellung eines Schnittes durch ein zweites Ausführungsbeispiel des Verkapselungsschlauches;
Figur 3, eine schematische Darstellung eines Schnittes durch ein viertes Ausführungsbeispiel des Verkapselungsschlauches;
   und
Figur 4, eine schematische Darstellung einer perspektivischen Ansicht eines Verkapselungsschlauches gemäß einem der beiden Ausführungsbeispiele.

In den unterschiedlichen Ausführungsbeispielen, Ausführungsformen und Ausgestaltungen sind gleiche und gleichwirkende Bestandteile figurenübergreifend jeweils mit denselben Bezugszeichen versehen. Die Figuren sind grundsätzlich nicht maßstabsgetreu. Die Größenverhältnisse der verschiedenen Bestandteile untereinander entsprechen nicht der Wirklichkeit. Beispielsweise können vergleichsweise kleine Elemente zur besseren Veranschaulichung übertrieben groß dargestellt sein und umgekehrt.

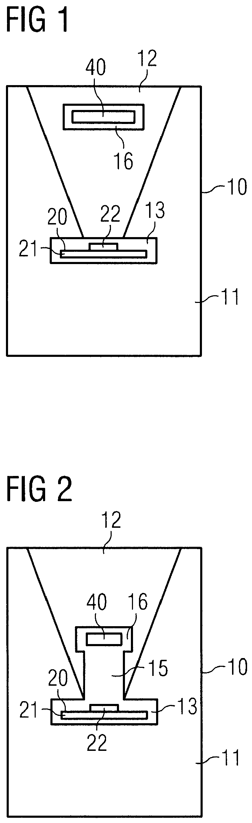

Das in Figur 1 dargestellte Ausführungsbeispiel umfasst einen langgestreckten Verkapselungsschlauch 10, der von einem langgestreckten Trägerelement 11 und einem langgestreckten Fensterelement 12 gebildet ist. In diesem Verkapselungsschlauch 10 ist ein LED-Kanal 13 vorgesehen, der in Längsrichtung des Verkapselungsschlauches 10 (im Folgenden nur allgemein mit "Längsrichtung" bezeichnet) durch den gesamten Verkapselungsschlauch 10 verläuft und der einerseits vom Trägerelement 11 und andererseits vom Fensterelement 12 begrenzt ist.

Der Verkapselungsschlauch 10 ist beispielsweise mittels Co-Extrusion hergestellt. Das Trägerelement 11 ist beispielsweise gefertigt aus einem Silikon-, PVC- oder PUR-Material oder aus einer Kombination dieser Materialien, welches beispielsweise mit einem Füllstoff (beispielsweise ein Weißpigment) gefüllt ist, der eine von den LED-Chips emittierte Strahlung reflektiert und das Fensterelement 12 ist beispielsweise aus einem transparenten oder transluzenten Silikon-, PVC- oder PUR-Material oder einer Kombination dieser Materialien gefertigt. Das Fensterelement 12 kann alternativ beispielsweise aus zwei oder mehr Schichten aufgebaut sein, von denen eine (beispielsweise eine äußere Schicht) transparent und eine (beispielsweise eine innere Schicht) transluzent ist, um eine Homogenisierung des von den LEDs ausgesandten Lichts zu erzielen.

Nach Herstellung des Verkapselungsschlauches 10 kann in den LED-Kanal 13 ein LED-Lichtband 20 eingezogen und montiert werden. Dieses umfasst beispielsweise ein Flex-PCB 21 mit einer Mehrzahl von linear hintereinander montierten und elektrisch verschalteten LEDs 22, so wie es beispielsweise im Datenblatt BLONE1300024DC12000830000W20 (verfügbar unter https://cdn2.regroshop.at/medias/sys_Regro/sheets/sheets/h03/ hd8/9006597767198/Te-BL124120003020.pdf) beschrieben ist.

Das Fensterelement 12 weist mindestens einen entlang des LED-Kanals 13 verlaufenden Opto-Kanal 16 auf. Dieser weist für die von den LEDs ausgesandte Strahlung eine vorbestimmte optische Wirkung auf und/oder ist dazu vorgesehen, mindestens ein dahingehend optisch wirksames Opto-Element 40 (hier beispielhaft eingezeichnet), beispielsweise ein Band oder einen Streifen mit linear über die gesamte Länge des LED-Lichtbandes 20 angeordneten optischen Elementen, in den Verkapselungsschlauch 10 einzuziehen. Damit können Beleuchtungseigenschaften eines linearen Leuchtdiodenmoduls eingestellt werden.

Beispielsweise kann der Opto-Kanal 16 selbst oder das gegebenenfalls in diesen eingezogene Opto-Element lichtstreuende Eigenschaften aufweisen, beispielsweise vermittels Streupartikel. Zusätzlich oder alternativ kann der Opto-Kanal 16 selbst oder das Opto-Element 40 vermittels reflektiver und/oder diffraktiver optischer Elemente beispielsweise den Abstrahlwinkel des linearen Leuchtdiodenmoduls vorgeben und/oder eine asymmetrische Abstrahlung des linearen Leuchtdiodenmoduls hervorrufen.

Ebenso kann beispielsweise mittels geeigneter Formgebung des Fensterelements 12 und Verwendung einer asymmetrischen Linearlinse als Opto-Element 40 in einem seitlich zum LED-Lichtband verlaufenden Opto-Kanal 16 mittels eines Topview-LED-Lichtbandes ein lineares Sideview-Leuchtdiodenmodul realisiert werden.

Nach Montage des LED-Lichtbandes 20 und gegebenenfalls des Opto-Elements 40 werden zur Fertigstellung eines linearen Leuchtdiodenmoduls die Enden des Verkapselungsschlauches 10 beispielsweise mittels geeigneter Kappen oder anderweitiger Verschlussmittel, welche elektrische Durchführungen zum elektrischen Anschließen des Moduls aufweisen, verschlossen.

Das in Figur 2 dargestellte zweite Ausführungsbeispiel unterscheidet sich von dem ersten Ausführungsbeispiel von Figur 1 dadurch, dass der Opto-Kanal 16 zum LED-Kanal 13 hin einen entlang der Längsrichtung verlaufenden Spalt 15 aufweist. Dies ermöglicht beispielsweise, falls erforderlich, eine direkte optische Verbindung zwischen dem LED-Lichtband 21 und ggf. einem im Opto-Kanal 16 angeordneten Opto-Element 40 des linearen Leuchtdiodenmoduls.

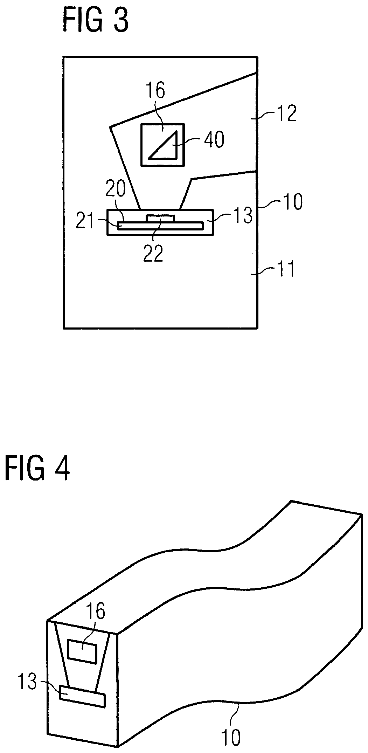

Das Ausführungsbeispiel gemäß Figur 3 unterscheidet sich von den vorangehend beschriebenen Ausführungsbeispielen dadurch, dass das Fensterelement 12 im Querschnitt senkrecht zur Längsrichtung derart gewinkelt ausgestaltet ist, dass das von den LEDs 22 emittierte Licht zu einer Seitenfläche des Verkapselungsschlauches 10 umgelenkt und dort ausgekoppelt wird. Sämtliche Elemente der oben beschriebenen Ausführungsbeispiele können auch in diesem Ausführungsbeispiel vorhanden sein. Beispielsweise kann in dem Opto-Kanal 16 des gewinkelten Fensterelements 12 als Opto-Element 40 ein optisches Prisma angeordnet sein.

Der in Figur 4 perspektivisch dargestellte Verkapselungsschlauch kann gemäß einem der oben beschriebenen Ausführungsbeispiele ausgestaltet sein. Dies wird durch den gestrichelt eingezeichneten Spalt 15 und die Klammern um das zugehörige Bezugszeichen angezeigt.

Die Erläuterung der Erfindung anhand der Ausführungsbeispiele ist nicht als Einschränkung der Erfindung auf diese zu verstehen. Vielmehr können die oben allgemein beschriebenen Elemente und die in den Ausführungsbeispielen beschriebenen Elemente je nach Anforderungsprofil für ein lineares Leuchtdiodenmodul unterschiedlich miteinander kombiniert werden und jedes einzelne Element beinhaltet für sich alleine den der Erfindung zugrundeliegenden eingangs geschilderten Gedanken.

### Bezugszeichenliste

- 1: Lineares Leuchtdiodenmodul
- 10: Verkapselungsschlauch
- 11: Trägerelement
- 12: Fensterelement
- 13: LED-Kanal
- 15: Spalt
- 16: Opto-Kanal
- 20: LED-Lichtband
- 21: Flex-PCB
- 22: LED
- 40: Opto-Element

## Patentansprüche

1. Verkapselungsschlauch (10) für ein mindestens ein LED-Lichtband (20) aufweisendes lineares Leuchtdiodenmodul (1), mit einem entlang dessen Längsrichtung allseitig geschlossenen vorgefertigten Profil, welches mit einem in Längsrichtung vollständig durch den Verkapselungsschlauch verlaufenden LED-Kanal (13) versehen ist, der dazu vorgesehen ist, in diesen das LED-Lichtband (20) einzuziehen, wobei der LED-Kanal (13) einerseits von einem lichtreflektierenden Trägerelement (11) und andererseits von einem lichtdurchlässigen Fensterelement (12) begrenzt ist,
**dadurch gekennzeichnet, dass**
das Fensterelement (12) mindestens einen entlang des LED-Kanals (13) verlaufenden Opto-Kanal (16) aufweist, der dazu ausgebildet ist, für die vom LED-Lichtband (20) ausgesandte Strahlung eine vorbestimmte optische Wirkung hervorzurufen, und/oder der dazu vorgesehen ist, in diesen mindestens ein Opto-Element (40) einzuziehen.

2. Verkapselungsschlauch gemäß Anspruch 1,
**dadurch gekennzeichnet, dass**
der Opto-Kanal (16) in dessen Längsrichtung allseitig vom Trägerelement (11) umschlossen ist.

3. Verkapselungsschlauch gemäß Anspruch 1,
**dadurch gekennzeichnet, dass**
der Opto-Kanal (16) zum LED-Kanal (13) hin einen entlang dessen Längsrichtung verlaufenden Spalt (15) aufweist.

4. Verkapselungsschlauch gemäß Anspruch 3,
**dadurch gekennzeichnet, dass**
der Spalt (15) über die gesamte Länge des Verkapselungsschlauches (10) durchgängig ist.

5. Verkapselungsschlauch nach mindestens einem der vorangehenden Ansprüche,
**dadurch gekennzeichnet, dass**
der Opto-Kanal (16) lichtstreuende Eigenschaften aufweist.

6. Verkapselungsschlauch nach mindestens einem der vorangehenden Ansprüche,
**dadurch gekennzeichnet, dass**
der Opto-Kanal (16) derart lichtreflektierende und/oder lichtbrechende Flächen aufweist, die den Abstrahlwinkel des linearen Leuchtdiodenmoduls vorgeben und/oder eine asymmetrische Abstrahlung des LED-Lichtbandes hervorrufen.

7. Verkapselungsschlauch nach mindestens einem der vorangehenden Ansprüche,
**dadurch gekennzeichnet, dass**
das Fensterelement und das Trägerelement derart geformt und reflektierend ausgebildet sind, dass mittels eines Topview-LED-Lichtbandes ein lineares Sideview-Leuchtdiodenmodul realisierbar ist.

8. Lineares Leuchtdiodenmodul (1) mit einem Verkapselungsschlauch gemäß einem der Ansprüche 1 bis 7.

9. Lineares Leuchtdiodenmodul (1) mit einem Verkapselungsschlauch gemäß einem der Ansprüche 1 bis 7, bei dem im Opto-Kanal (16) ein Opto-Element (4) mit linear angeordneten optischen Elementen eingezogen ist, die den LEDs 22 auf einem in den LED-Kanal (13) eingezogenen LED-Lichtband 20 zugeordnet sind.
